# EUROPEAN PATENT APPLICATION

(11) **EP 2 977 995 A1**
(43) Date of publication of application: **27.01.2016**
(21) Application number: 14770981.0
(22) Date of filing: 21.02.2014
(51) Int. Cl.: H01F 27/08, H01F 30/00, H01F 37/00, H05K 7/20

(54) **COOLING STRUCTURE FOR MAGNETIC COMPONENT, AND POWER CONVERTER PROVIDED WITH SAME**

(30) Priority: 19.03.2013 JP 2013056930
(71) Applicant: Fuji Electric Co., Ltd., Kawasaki-shi, Kanagawa 210-9530 (JP)
(72) Inventor: SAKUMA, Masaki, Kawasaki-shi, Kanagawa 210-9530 (JP); GEKINOZU, Masakazu, Kawasaki-shi, Kanagawa 210-9530 (JP); NISHIKAWA, Yukihiro, Kawasaki-shi, Kanagawa 210-9530 (JP); TANAKA, Yasuhito, Kawasaki-shi, Kanagawa 210-9530 (JP)
(74) Representative: Appelt, Christian W.
(86) International application number: PCT/JP2014/000919
(87) International publication number: WO 2014/147960

(57) **Abstract**

A cold air flow path space is provided in which cold air is caused to flow inside a housing (2) by an internal fan (14) disposed inside the housing. A magnetic component (20) mounted on the bottom portion of the housing is fixed by an attachment member (30) at a position that is in the cold air flow path space and faces a suction side (14b) of the internal fan. Further, the flow of the cold air generated on the suction side of the internal fan passes inside the magnetic component.

## Description

### TECHNICAL FIELD

The present invention relates to a structure for cooling a magnetic component located inside a housing and to a power converter provided with the cooling structure.

### BACKGROUND ART

In a power converter such as an AC/DC converter, a magnetic component such as a transformer is located inside a housing, and the magnetic component is typically fixed to a bottom portion of the housing. When the magnetic component is located inside the housing, since the magnetic component is a heat-generating body, the magnetic component is required to be cooled with good efficiency.

For example, a device disclosed in Patent Literature 1 is known as a conventional device for cooling a transformer.

In the cooling device for a transformer which is disclosed in Patent Literature 1, a transformer including an iron core and coils wound on the iron core is accommodated in a duct, a blast fan that blows cold air toward the outer circumference of the transformer coils and a blast fan that blows cold air toward the rear surface of the transformer are provided in the duct, and the transformer is cooled by cold air generated by those blast fans.

Patent Literature 1: Japanese Patent Application Publication No. 2008-187014

### DISCLOSURE OF THE INVENTION

However, in the device disclosed in Patent Literature 1, the cold air generated by the blast fans spreads while flowing toward the transformer, and the amount of cold air coming into contact with the outer circumference of the coils and the rear surface of the coils can be decreased, thereby creating a problem with cooling efficiency.

Further, in the device disclosed in Patent Literature 1, dedicated blast fans are required for cooling the transformer, which can result in the increased production cost.

Furthermore, with the structure in which a plurality of blast fans is attached to the duct accommodating the transformer, a problem is associated with a space for arranging other components when such are to be disposed inside the housing.

With the foregoing in view, it is an objective of the present invention to provide a cooling structure for a magnetic component and a power converter provided with the cooling structure, which are of a small size and inexpensive and which resolve the problem associated with an arrangement space for other components while increasing the cooling efficiency of the magnetic component.

In order to attain the abovementioned objective, a cooling structure for a magnetic component according to an aspect of the present invention is a structure for cooling a magnetic component located inside a housing, wherein a cold air flow path space is provided in which cold air is caused to flow inside the housing by an internal fan disposed inside the housing, and the magnetic component mounted on a bottom portion of the housing is fixed by an attachment member at a position that is in the cold air flow path space and faces a suction side of the internal fan, such that a flow of cold air generated on the suction side of the internal fan passes inside the magnetic component.

With the cooling structure for a magnetic component according to the abovementioned aspect, the adjusted flow of cooling air that is generated on the suction side of the internal fan comes into contact with the coil inside the magnetic component. Therefore, the heat generated by the coil is dissipated and the cooling efficiency of the magnetic component is increased.

Further, in the cooling structure for a magnetic component according to the abovementioned aspect of the present invention, the attachment member is a metal plate member provided with a top plate which abuts against an upper surface of the magnetic component, and a pair of legs which extend downward from the top plate and are fixed to the bottom portion of the housing.

With the cooling structure for a magnetic component according to the abovementioned aspect, the attachment member has a simple structure constituted by a metal plate member. Therefore, the production cost can be reduced.

Further, in the cooling structure for a magnetic component according to the abovementioned aspect of the present invention, the bottom portion of the housing on which the magnetic component is mounted is a cooling body.

With the cooling structure for a magnetic component according to the abovementioned aspect, the heat generated by the magnetic component is directly transferred from the attachment member to the bottom portion of the housing which is a cooling body. Therefore, the cooling efficiency of the magnetic component is further increased.

Further, a power converter according to an aspect of the present invention, is provided with the above-described cooling structure for a magnetic component and converts alternative current power into direct current power.

With the power converter according to the abovementioned aspect, a small-size and inexpensive power converter can be provided while increasing the cooling efficiency of the magnetic component.

With the cooling structure for a magnetic component and the power converter provided therewith in accordance with the present invention, the magnetic component is disposed at the position that is in the cold air flow path space and faces the suction side of the internal fan, such that a flow of cold air generated on the suction side of the internal fan passes inside the magnetic component. As a result, the adjusted cold air generated by the internal fan comes, in an increased amount, into contact with the coil inside the magnetic component. Therefore, the heat generated by the coil is dissipated and the cooling efficiency of the magnetic component can be increased.

### BRIEF DESCRIPTION OF THE DRAWINGS

FIG. 1 is a perspective view of a power converter provided with the cooling structure for a magnetic component according to an aspect of the present invention.
FIG. 2 is a plan view of the interior of the power converter from which a lid has been removed.
FIG. 3 is a view of the case constituting the housing which is taken from the chamber-forming wall side.
FIG. 4 is a principal enlarged view of FIG. 3.
FIG. 5 illustrates the configuration of the transformer located inside the housing of the power converter, FIG. 5(a) being a perspective view of the constituent members of the transformer, and FIG. 5(b) being a cross-sectional view of the assembled transformer.
FIG. 6 illustrates a state in which the transformer of the power converter is fixed to the housing by the attachment member, FIG. 6(a) being a plane view, FIG. 6(b) being a side view, and FIG. 6(c) being a sectional view taken along the C-C line in FIG. 6(a).
FIG. 7 shows the image of a cold air flow inside the case which is generated when the internal fan is driven.

### BEST MODE FOR CARRYING OUT THE INVENTION

An embodiment of a power converter including a cooling structure for a magnetic component according to an aspect of the present invention will be explained hereinbelow with reference to the drawings.

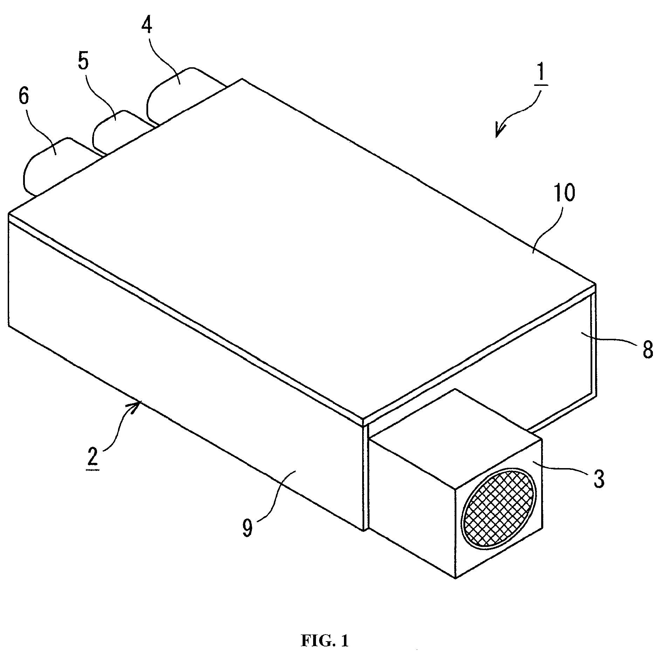

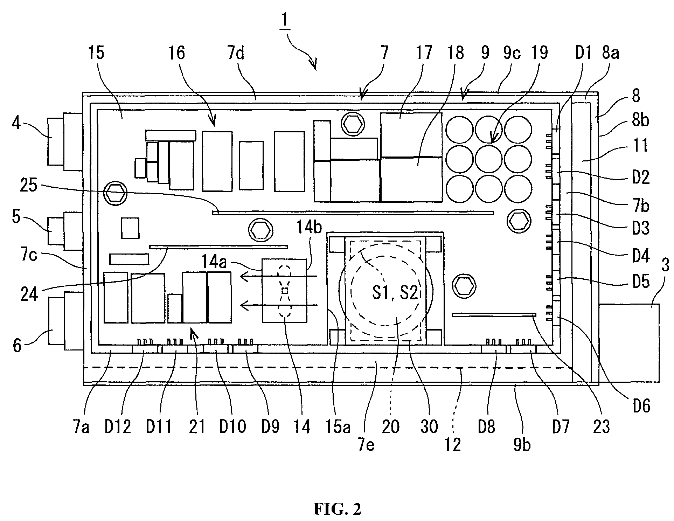

FIG. 1 depicts a power converter 1 according to the first embodiment which is used as an AC/DC converter. FIG. 2 depicts the interior of the power converter 1 from which a lid 10 has been removed.

As depicted in FIG. 1, a blast fan 3 is externally attached to one longitudinal side surface of a rectangular parallelepiped housing 2 constituting the power converter 1. An input connector 4, a control connector 5, and an output connector 6 are provided in parallel at the other longitudinal side surface of the housing 2. The below-described power conversion control unit is located inside the housing 2, and where a control signal is input to the control connector 5, commercial power input to the input connector 4 is AC-DC converted by the power conversion control unit and output as DC power from the output connector 6.

As depicted in FIGS. 1 and 2, the housing 2 is constituted by a case 7, a chamber-forming wall 8, a housing cover 9, and a lid 10.

The case 7 is configured as a rectangle in a plan view thereof, has a bottomed box shape, and includes a rectangular bottom portion 7a and a pair of short-side sidewalls 7b, 7c and a pair of long-side sidewalls 7d, 7e rising from four sides of the bottom portion 7a. The case 7 is formed by die-cast molding, for example, aluminum or an aluminum alloy having high thermal conductivity.

The chamber-forming wall 8 is constituted by an abutment wall 8a which is disposed on one longitudinal side of the case 7 and abuts against one short-side sidewall 7b of the case 7 and an opposing wall 8b that faces the one short-side sidewall 7b of the case 7.

The housing cover 9 is provided to cover part of the case 7 and the chamber-forming wall 8. The lid 10 is provided to close upper openings of the case 7 and chamber-forming wall 8 and seal the interior of the housing 2.

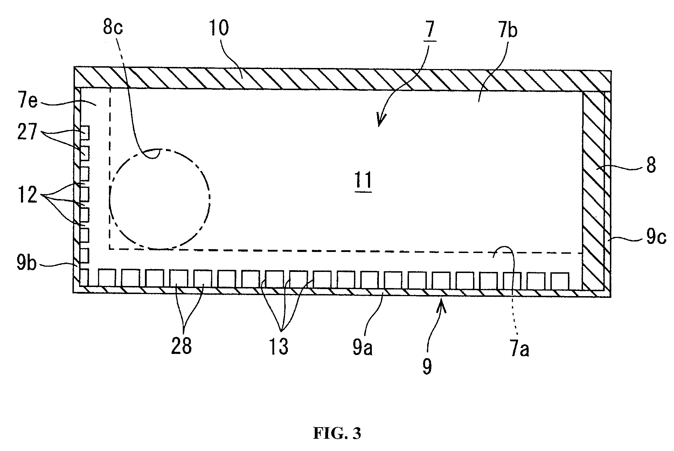

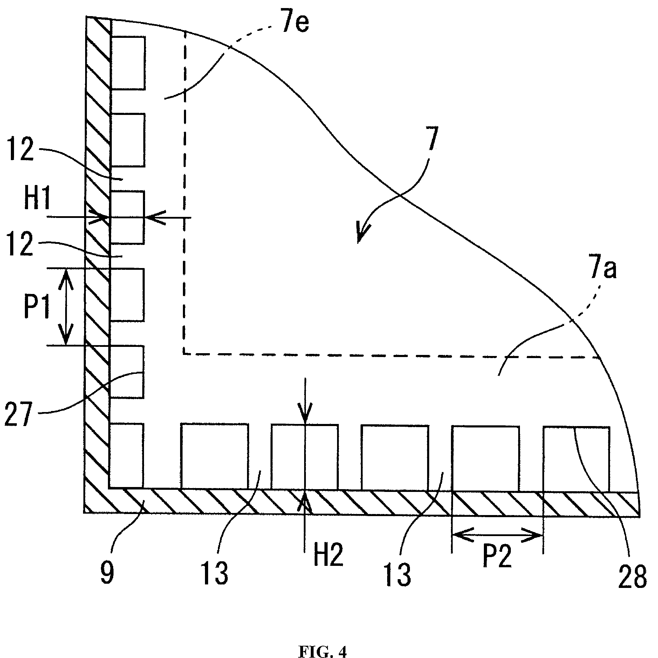

As depicted in FIG. 3, a plurality of sidewall fins 12 extending in the longitudinal direction is provided at one long-side sidewall 7e of the case 7 in a region from the lower end of the outer side thereof to the upper part. The plurality of sidewall fins 12 is formed parallel to each other at a predetermined interval in the vertical direction of the long-side sidewall 7e. As depicted in FIG. 4, the height of each sidewall fin 12 is set to H1, and a pitch of the sidewall fins 12 is set to P1. As depicted in FIG. 2, the sidewall fins are not formed on the outer side of the other long-side sidewall 7d of the case 7.

Further, as depicted in FIG. 3, a plurality of bottom fins 13 extending in the longitudinal direction is also provided at the bottom portion 7a of the case 7 in a region from a left end of the lower surface of the bottom portion to the right side. The plurality of bottom fins 13 is formed parallel to each other at a predetermined interval in the lateral direction of the bottom portion 7a. As depicted in FIG. 4, the height of each bottom fin 13 is set to a value H2 (H2 > H1) which is larger than the height H1 of the sidewall fin 12. The pitch of the bottom fins 13 is set to a value P2 (P2 > P1) which is larger than the pitch P1 of the sidewall fin 12.

The housing cover 9 is a cover member that covers the sidewall fins 12 and the bottom fins 13 from the outer side and is configured, as depicted in FIGS. 2 and 3, of a rectangular plate-shaped bottom plate 9a that covers the bottom portion 7a of the case 7 and the lower opening of the chamber-forming wall 8, and a pair of side plates 9b, 9c that rise from the edge of the bottom plate 9a and cover the pair of long-side sidewalls 7d, 7e of the case 7 and the side portion of the chamber-forming wall 8.

Thus, as shown in FIG. 3, spaces between the plurality of sidewall fins 12 and the spaces between the plurality of bottom fins 13 serve as a plurality of flow paths 27, 28 extending in the longitudinal direction of the case 7 at the outer circumference of the bottom portion 7a of the case 7 and one long-side sidewall 7e which are covered by the housing cover 9. Further, the lid 10 is fixed to the case 7 and the chamber-forming wall 8 in a manner such as to close the upper openings of the case 7 and the chamber-forming wall 8. As a result, an internal space bounded by one short-side sidewall 7b of the case 7, the chamber forming wall 8, the housing cover 9, and the lid 10 is defined as a chamber 11 which is a wind tunnel.

One longitudinal end of each of the plurality of flow paths 27, 28 formed between the housing cover 9, the bottom portion 7a of the case 7, and the outer circumference of the one long-side sidewall 7e communicates with the chamber 11, and the other end of the flow paths 27, 28 communicates with the atmosphere. An opening 8c serving as an air inlet is formed in the opposing wall 8b of the chamber forming wall 8. Further, the blast fan 3 is mounted such that the outlet of the blast fan 3 faces the position of the opening 8c, and cooling air generated by the blast fan 3 is fed into the chamber 11.

The power conversion control unit and an internal fan 14 are accommodated inside the case 7.

As depicted in FIG. 2, the power conversion control unit is configured of control components such as a base substrate 15, an input-side noise filter unit 16, a first reactor 17, a second reactor 18, an electric field capacitor group 19, a transformer 20, an output-side noise filter unit 21, a plurality of semiconductor devices (for example, MOS-FET) D1 to D12, and first to third circuit substrate 23 to 25.

The base substrate 15 is a member having a rectangular shape that is less in size than the planar shape of the bottom portion 7a of the case 7. A cut-out portion 15a is formed in one long side of the base substrate. A predetermined wiring pattern (not shown in the figure) that is connected to the above-described input connector 4, control connector 5, and output connector 6 is formed on the base substrate 15. The base substrate 15 is fastened with a bolt and fixed to a support base (not shown in the figure) formed at the upper surface of the bottom portion 7a of the case 7, such that the cut-out portion 15a faces the case 7 on one long-side sidewall 7e side.

The input-side noise filter unit 16, the first reactor 17, the second reactor 18, the electric field capacitor group 19, the output-side noise filter unit 21, the semiconductor devices D1 to D12, and the first to third circuit substrates 23 to 25 are mounted on the base substrate 15, and the internal fan 14 is also disposed on the base substrate 15.

Further, as depicted in FIG. 2, a transformer 20 is disposed inside the cut-out portion 15a of the base substrate 15, and this transformer 20 is directly fixed by an attachment member 30 to the bottom portion 7a of the case 7.

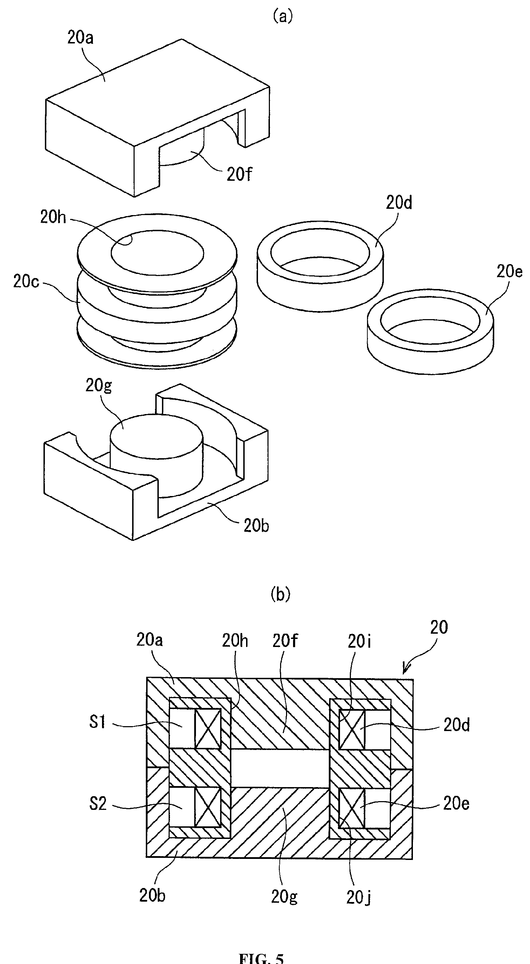

As depicted in FIG. 5(a), the transformer 20 is provided with an upper core 20a, a lower core 20b, a substantially cylindrical bobbin 20c, a primary coil 20d, and a secondary coil 20e. Further, as depicted in FIG. 5(b), the transformer 20 is formed by mating a protrusion 20f provided at the upper core 20a and a protrusion 20g provided at the lower core 20b, from above and below, with a mating hole 20h formed along the axis of the bobbin 20c, arranging the wound primary coil 20d in an upper coil accommodation recess 20i provided in the upper portion of the bobbin 20c, and arranging the wound secondary coil 20e in a lower coil accommodation recess 20j provided in the lower portion of the bobbin 20c.

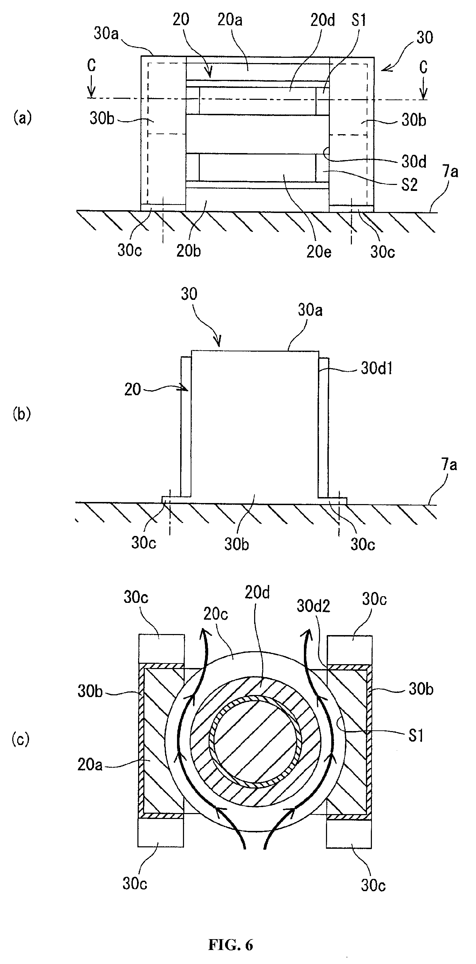

As depicted in FIGS. 6(a) and 6(b), the attachment member 30 is a metal plate member including a quadrangular top plate 30a that abuts against the upper surface of the upper core 20a of the transformer 20, a pair of legs 30b extending downward parallel to each other from edge portions of two mutually opposing sides of the top plate 30a, and a fixing portion 30c extending in the orthogonal direction from the lower ends of the pair of legs 30b.

As depicted in FIGS. 6(a) and 6(c), a gap S1 is formed between the upper surface of the upper core 20a and the wound primary coil 20d arranged in the upper coil accommodation recess 20i, and this gap S1 serves as a flow path space inside the transformer in which cold air flows from one opening 30d1 to another opening 30d2 (referred to hereinbelow as "flow path space S1 inside the transformer"). Further, a gap S2 is formed between the inner surface of the lower core 20b and the wound secondary coil 20e arranged in the lower coil accommodation recess 20j. The gap S2 also serves as a flow path space inside the transformer in which cold air flows from one opening 30d1 to another opening 30d2 (referred to hereinbelow as "flow path space S2 inside the transformer").

Specific arrangement of the control components and the internal fan 14 will be explained hereinbelow with reference to FIG. 5.

The semiconductor devices D1 to D6 are mounted at a predetermined interval in the arrangement direction along one short side of the base substrate 15. The mounting positions of the semiconductor devices D1 to D6 are such that the devices are in direct contact with one short-side sidewall 7b of the case 7 that defines the chamber 11. Other semiconductor devices D7 to D12 are mounted at a predetermined interval in the arrangement direction along one long side of the base substrate 15. The mounting positions of the semiconductor devices D7 to D12 are such that the devices are in direct contact with one long-side sidewall 7e of the case 7 that forms the sidewall fins 12.

Further, the third circuit substrate 25 is mounted to rise and extend in the longitudinal direction at a center position, in the lateral direction, of the base substrate 15. The second circuit substrate 24 is mounted on the base substrate 15 such as to extend in the longitudinal direction at a position close to the other short-side sidewall 7c of the case 7 while rising parallel to the third circuit substrate 25. The input-side noise filter unit 16, the first reactor 17, the second reactor 18, and the electric field capacitor group 19 are mounted on the base substrate 15 such as to be positioned between the third circuit substrate 25 and the other long-side sidewall 7d of the case 7. The output-side noise filter unit 21 is mounted on the base substrate 15 such as to be positioned between the second circuit substrate 24 and the one long-side sidewall 7e of the case 7.

The first circuit substrate 23 is mounted such as to rise and extend in the longitudinal direction of the base substrate 15, so as to be parallel to the one long-side sidewall 7e, at a position close to the one short-side sidewall 7b.

The internal fan 14 is disposed on the base substrate 15 at a position close to the one long-side sidewall 7e between the output-side noise filter unit 21 and the transformer 20 and arranged such that a blow side 14a thereof faces the output-side noise filter unit 21 and a suction side 14b faces the transformer 20.

The transformer 20 is directly fixed to the bottom portion 7a by connecting the fixing portion 30c of the attachment member 30 to the bottom portion 7a of the case 7 by a fixing screw (not shown in the figure).

The operation of the power converter 1 and the cooling action are explained hereinbelow.

Where a control signal is input to the control connector 5 of the power converter 1 of the present embodiment, commercial electric power input to the input connector 4 is AC-DC converted by the power conversion control unit accommodated inside the case 7 and output as DC power from the output connector 6. In this case, the control components such as the transformer 20 and the power conversion control unit located inside the case 7 generate heat. The amount of heat generated by the primary coil 20d and the secondary coil e of the transformer 20 is particularly large.

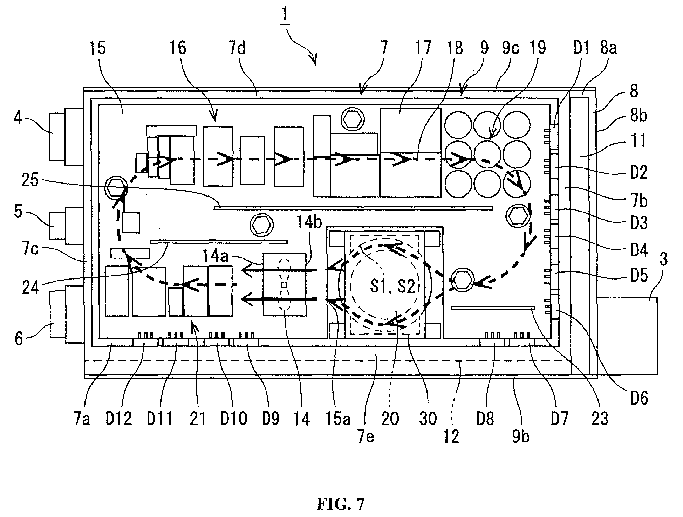

Where the internal fan 14 is driven, the third circuit substrate 25, which is mounted to rise at the center position in the lateral direction of the base substrate 15, and the second circuit substrate 24 function as air guiding plates, and a cold air flow is generated which circulates in the output-side noise filter unit 21, the input-side noise filter unit 16, the first reactor, the second reactor, the electric field capacitor group 19, and the transformer 20, in the order of description, as indicated by a broken-line arrow in FIG. 7.

In this case, the suction side 14b of the internal fan 14 sucks in the surrounding air as a flow adjusted to a substantially constant flow velocity. Therefore, the adjusted flow of cold air passes in an increased air amount through the flow path spaces S1, S2 of the transformer 20 that faces the suction side 14b of the internal fan 14.

Since the adjusted cold air flow generated at the suction side 14b of the internal fan 14 thus flows in an increased air amount through the flow path spaces S1, S2 of the transformer 20, the heat generated at the primary coil 20d and the secondary coil e of the transformer 20 is dissipated.

The cold air blown from the blow side 14a of the internal fan 14 comes into contact with the output-side noise filter unit 21 which has a small heat generation amount, without coming into contact with the control components which have a large heat generation amount, such as the semiconductor devices D7 to D12 and the transformer 20. Therefore, heat generated by other control components (the output-side noise filter unit 21, the input-side noise filter unit 16, the first reactor, the second reactor, and the electric field capacitor group 19) is also dissipated.

Where the blast fan 3 is driven, cold air taken from the outside is fed into the chamber 11. The cold air fed into the chamber 11 enters a plurality of passages 28 formed on the bottom portion 7a side of the case 7 communicating with the chamber 11 and is discharged to the outside. Therefore, the bottom portion 7a becomes a cooling body. The cold air also enters a plurality of flow paths 27 formed on the one long-side sidewall 7e side communicating with the chamber 11 and is then discharged to the outside. Therefore, the one long-side sidewall 7e also becomes a cooling body.

Further, since the transformer 20 is fixed such as to be in direct contact with the bottom portion 7a of the case 7 which is the cooling body, the heat generated by the transformer 20 is directly transferred from the attachment member 30 to the bottom portion 7a and dissipated.

The cold air flow path space according to the present invention corresponds to the cold air flow circulating in the output-side noise filter unit 21, input-side noise filter unit 16, the first reactor, the second reactor, the electric field capacitor group 19, and the transformer 20 in the order of description.

The effect of the embodiment is explained hereinbelow.

In the present embodiment, the adjusted cold air flow generated on the suction side 14b of the internal fan 14 flows in an increased amount in the flow path spaces S1, S2 inside the transformer 20. Therefore, the heat generated by the primary coil 20d and the secondary coil e of the transformer 20 is dissipated by the cold air flowing in the flow path spaces S1, S2 inside the transformer and the cooling efficiency of the transformer 20 can be sufficiently increased.

Further, since the transformer 20 is fixed such as to be in direct contact with the bottom portion 7a of the case 7, which is the cooling body, the heat generated by the transformer 20 is directly transferred from the attachment member 30 to the bottom portion 7a and the cooling efficiency of the transformer 20 can be further increased.

Further, since the internal fan 14 blows cold air on the control component (output-side noise filter unit 21) side with a small heat generation amount, other components (the output-side noise filter unit 21, the input-side noise filter unit 16, the first reactor, the second reactor, and the electric field capacitor group 19) can be also cooled efficiently.

Since the attachment member 30 has a simple structure such that no fan is mounted on the attachment member 30 that fixes the transformer 20, the production cost can be reduced and sufficient arrangement space can be ensured inside the case 7.

The embodiment of the present invention is explained hereinabove, but the present invention is not limited thereto and various changes and modifications can be made. For example, the magnetic component is not limited to the transformer 20, and other heat-generating electronic components, such as a reactor, may be also used.

Further, the attachment member 30 equipped with the pair of legs 30b is described by way of example in the present embodiment, but the legs forming a pair may be further split. For example, the attachment member may be shaped to have a total of four legs in pairs, each pair including two legs.

### INDUSTRIAL APPLICABILITY

As mentioned hereinabove, the cooling structure for a magnetic component and a power converter provided therewith in accordance with the present invention are useful for obtaining small-size inexpensive cooling structure and power converter which resolve the problem associated with an arrangement space for other components while increasing the cooling efficiency of the magnetic component.

### EXPLANATION OF REFERENCE NUMERALS

1 - power converter, 2 - housing, 3 - blast fan, 4 - input connector, 5 - control connector, 6 - output connector, 7 - case, 7a - bottom portion, 7b - short-side sidewall, 7c - short-side sidewall, 7d - long-side sidewall, 7e - long-side sidewall, 8 - chamber-forming wall, 8a - abutment wall, 8b - opposing wall, 8c - opening, 9 - housing cover, 9a - bottom plate, 9b, 9c - side plates, 10 - lid, 11 - chamber, 12 - sidewall fin, 13 - bottom fin, 14 - internal fan, 14a - blow side, 14b - suction side, 15 - base substrate, 15a - cut-out portion, 16 - input-side noise filter unit, 17 - first reactor, 18 - second reactor, 19 - electric field capacitor group, 20 - transformer, 20a - upper core, 20b - lower core, 20c - bobbin, 20d - primary coil, 20e - secondary coil, 20f - protrusion, 20g - protrusion, 20h - mating hole, 20i - upper coil accommodation recess, 20j - lower coil accommodation recess, 21 - output-side noise filter unit, 23 - first circuit substrate, 24 - second circuit substrate, 25 - third circuit substrate, 26 - support base, 27, 28 - flow paths, 30, 31 - attachment members, 30a, 31a - top plates, 30b, 31b - legs, 30c, 31d - fixing portions, 30d1 - one opening, 30d2 - another opening, S1, S2 - flow path spaces in transformers, D1 to D12 - semiconductor devices

## Claims

1. A cooling structure for a magnetic component, which is a structure for cooling a magnetic component located inside a housing, wherein
a cold air flow path space is provided in which cold air is caused to flow inside the housing by an internal fan disposed inside the housing, and
the magnetic component mounted on a bottom portion of the housing is fixed by an attachment member at a position that is in the cold air flow path space and faces a suction side of the internal fan, such that a flow of cold air generated on the suction side of the internal fan passes inside the magnetic component.

2. The cooling structure for a magnetic component according to claim 1, wherein the attachment member is a metal plate member provided with a top plate which abuts against an upper surface of the magnetic component, and a pair of legs which extend downward from the top plate and are fixed to the bottom portion of the housing.

3. The cooling structure for a magnetic component according to claim 1, wherein the bottom portion of the housing on which the magnetic component is mounted is a cooling body.

4. A power converter comprising the cooling structure for a magnetic component according to any one of claims 1 to 3, the power converter converting alternative current power into direct current power.
